(19) Europäisches Patentamt
European Patent Office
Office européen des brevets

(11) **EP 2 101 379 A1**

(12) **EUROPÄISCHE PATENTANMELDUNG**

(43) Veröffentlichungstag:
**16.09.2009 Patentblatt 2009/38**

(51) Int Cl.:
*H01S 5/026* (2006.01)   *H01S 5/183* (2006.01)
*H01S 5/20* (2006.01)

(21) Anmeldenummer: **09003664.1**

(22) Anmeldetag: **13.03.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**
Benannte Erstreckungsstaaten:
**AL BA RS**

(30) Priorität: **14.03.2008   DE 102008014193**

(71) Anmelder: **Universität Stuttgart**
**70174 Stuttgart (DE)**

(72) Erfinder:
• **Michler, Peter, Prof. Dr.**
**70806 Kornwestheim (DE)**
• **Jetter, Michael, Dr.**
**70563 Stuttgart (DE)**
• **Rossbach, Robert, Dr.**
**72827 Wannweil (DE)**

(74) Vertreter: **Pietruk, Claus Peter**
**Heinrich-Lilienfein-Weg 5**
**76229 Karlsruhe (DE)**

(54) **VCSEL mit monolithisch integrierter Fresnel-Linse**

(57)     Die Erfindung betrifft einen Vertikal-Resonator-Laser (1) mit einer Oberfläche zur Strahlemission (2) und einer gitterangepassten Beugestruktur (4) zur Bestimmung von Strahleigenschaften.

Die Beugestruktur ist eine Fresnel-Linse (4), welche durch selektives Ätzen einer Halbleiterschicht (3a1) mit hohem Al-Gehalt und einer Ätzstopschicht mit niedrigem Al-Gehalt (3a2) hergestellt wird.

Fig.1

EP 2 101 379 A1

**Beschreibung**

Die vorliegende Erfindung betrifft das oberbegrifflich Beanspruchte und bezieht sich somit auf Verbesserungen an Halbleiter-Lasern.

Laser sind seit langem bekannt. Sie umfassen ein aktives Medium, in welchem hindurchlaufendes Licht nicht abgeschwächt, sondern verstärkt wird, sowie Reflektoren, die eine spontan entstandene Lichtwelle immer wieder in das verstärkende Medium zurückreflektieren. Die Verwendung von Halbleitern als aktives Medium hat es ermöglicht, sehr kompakte Laser in Form von Laserdioden herzustellen. Um die Lichtwelle immer wieder in dieses verstärkende Halbleiter-Medium zurückzuwerfen, können auf beiden Seiten des aktiven Mediums eine Vielzahl von Schichten vorgesehen werden, die alternierend hohe und niedrige Brechungsindizes aufweisen und jeweils eine bestimmte Dicke besitzen. Derartige Schichten werden als verteilte Bragg-Reflektoren (distributed bragg reflectors, DBR) bezeichnet. Weil diese Struktur, die als Kavität beziehungsweise Resonator bezeichnet wird, in übereinanderliegenden Schichten aufgebaut ist, wird sie als vertikale Kavität bezeichnet. Die Emission von Licht erfolgt bei derartigen Lasern aus der Oberfläche heraus (und nicht wie bei anderen Halbleiter-Lasern an einer Kante). Daher wird ein solcher Laser entsprechend seiner englischen Bezeichnung "vertical-cavity surface-emitting laser", kurz VCSEL bezeichnet. Derartige Vertikal-Resonator-Laser sind schon deshalb, weil sie Licht senkrecht zur Oberfläche emittieren, besonders leicht zu testen, was bei Herstellung und Betrieb von Vorteil ist. Zudem ist es ohne weiteres möglich, mit ihnen Felder aus Einzelelementen herzustellen, wobei auch die mögliche Strahlprofilformung, insbesondere die Herstellung von kreisförmigen Strahlprofilen, von Vorteil ist.

Halbleiter-Laser, insbesondere VCSELs haben in den vergangenen Jahren erheblich an Bedeutung gewonnen, weil sie preiswert herzustellen sind, was Massenmärkte wie Datenspeicher, CDs und dergleichen zugänglich gemacht hat. Da sie aufgrund ihrer elektrischen Eigenschaften gut modulierbar sind, werden sie auch für die Datenübertragung eingesetzt. Dass darüber hinaus andere Anwendungen wie im Automobilbereich, bei Laserdruckern und -kopierern, in der Atomspektroskopie, bei medizinischen Behandlungen usw. bekannt sind, sei nur beispielsweise erwähnt. Es gibt entsprechend der Bedeutung von VCSELs eine Vielzahl von Veröffentlichungen, die sich mit Verbesserungen dieser Laser befassen. So beschreibt die EP 1 309 051 B1 einen optischen Datenübertragungspfad, enthaltend eine oberflächenemittierende Laserdiode mit Vertikal-Resonator und eine Fotodiode mit Resonanzkavität. Die EP 1 309 051 geht dabei einleitend auf das sogenannte Modenverhalten ein. Das Modenverhalten bestimmt, wie sich die Energie des emittierten Lichtstrahls über seinen Querschnitt verteilt und auf welcher genauen Frequenz der Laser emittiert. Gerade für den Kommunikationsbereich, bei dem sogenannte Single-Mode-Lichtleiter verwendet werden, welche nur eine einzige Strahlprofil-Mode übertragen können, ist es vorteilhaft, das Modenverhalten genau zu kontrollieren. Die EP 1 309 051 B1 schlägt dazu vor, dass ein optischer Datenpfad mit einem VCSEL zum Bereitstellen einer Lichtausgabe einen integrierten Resonanzreflektor aufweist, der eine Ausrichtung hat, welche die Lichtausgabe in einer ersten Richtung polarisiert, wobei eine Fotodiode mit Resonanzkavität einen integrierten Resonanzreflektor aufweisen soll und wobei der Resonanzreflektor der Fotodiode mit Resonanzkavität die gleiche Ausrichtung wie die VCSEL-Vorrichtung hat, so dass die erste Fotodiode mit Resonanzkavität die polarisierte Lichtausgabe der VCSEL-Vorrichtung erfasst. Es wird behauptet, dass die Eingliederung eines Resonanzreflektors in den oberen Spiegel zu äquivalenten oder überlegenen Reflektanzeigenschaften in einer Struktur führe, die fünf- bis zehnfach dünner als zuvor ist.

Aus der US 6,597,713 B2 ist eine Vorrichtung mit einem optisch funktionellen Element mit einer Spezialverdrahtungselektrode sowie ein Verfahren zur Herstellung derselben bekannt. Die US 6,597,713 B2 geht dabei von einem AlGaAs-GaAs-VCSEL aus. Die Vorrichtung umfasst ein erstes Substrat, wobei auf dem ersten Substrat ein erstes optisch funktionelles Element mit einem funktionellen Teil vorgesehen ist, und weiter eine erste Verdrahtungselektrode zum Injizieren eines Stromes in oder an dem funktionellen Teil des ersten optisch funktionellen Elementes vorgesehen ist, wobei die erste Verdrahtungselektrode auf dem ersten Substrat gebildet ist und einen ersten Teil umfasst, der elektrisch mit dem funktionellen Teil verbunden ist, sowie einen Erstreckungsteil, der sich von dem ersten Teil zu einer Außenseite des funktionellen Teils erstreckt und einen ersten Anschlussteil, der mit dem Erstreckungsteil außerhalb des funktionellen Teils verbunden ist, wobei die Vorrichtung weiter ein zweites Substrat umfasst und eine zweite Verdrahtungselektronik, und wobei die zweite Verdrahtungselektrode auf dem zweiten Substrat gebildet ist und einen zweiten Anschlussteil und einen zweiten Erstreckungsteil, der sich von dem ersten Anschlussteil erstreckt, umfasst, so dass das erste Substrat und das zweite Substrat aneinander gebondet sind, wobei der erste Anschlussteil und der zweite Anschlussteil elektrisch miteinander verbunden sind. Damit soll eine Anordnung geschaffen werden, die mit hoher Ausbeute günstig herzustellen ist. Es wird eine Ausführungsform beschrieben, bei welcher ein Verdrahtungssubstrat mit einer Fresnel-Linse versehen ist. Das Ausführungsbeispiel soll keine planen Mikrolinsen, die durch Diffusion gebildet sind, umfassen. Es wird eine Fresnel-Linse mit Ringstruktur angegeben, die einen Durchmesser von 1 $\mu$m und eine Tiefe von ungefähr 0,5 $\mu$m aufweisen soll, wobei das Design wellenlängenabhängig geändert werden soll. Es wird angegeben, dass sich die Anordnung sowohl für zweidimensionale VCSEL-Felder wie auch für einen einzelnen VCSEL anwenden lässt. Ungeachtet der Zielsetzung der US 6,597,713 ist die Herstellung jedoch noch kompliziert.

Aus dem Artikel "*Analysis of the Modulation Behaviour of Red VCSELs*" von T. Ballmann et al., SPIE 5597 (2004) 102, ist ein VCSEL für 650 nm bekannt, dessen aktiver Bereich mit GaInP-Aktivbereichen, die in AlGaInP eingebettet sind, aufgebaut ist.

GaInP-AlGaInP-VCSELs werden auch unter anderem diskutiert in dem Artikel "Red VCSEL for High-Temperature Applications" von R. Roßbach et al., J. Crystal Growth 272 (2004) 549, dem Artikel "AlGaInP-based-VCSEL2005" von R. Roßbach et al., IEEE Catalog Number 05CH37633C (2005) 161, in "Red VCSEL for Last Mile Networks" von M. Eichfelder et al., ITG-Fachbericht 197, Kommunikationskabelnetze, VDE-Verlag (256) 151, in "Red light VCSEL for high temperature application" von M. Jetter et al., SPIE 5594 (2004) 141, in "Analog Modulation of 650 nm VCSEL" von T. Ballmann et al., IEEE Phot. Tech. Lett. 18(4) (2006) 583 ff, in "Red surface emitters: powerful and fast" von H. Schweizer et al., SPIE 5248 (2003) 103 und in "Red VCSEL for automotive applications" von R. Roßbach et al., SPIE 5663 (2004) 135 sowie in "160°C pulsed laser operation of AlGaInP-based vertical-cavity surface-emitting lasers" von R. Roßbach et al., Electron. Lett. November, 13, 2003, Band 39, Nr. 23. Diese Artikel gehen auf unterschiedliche Aspekte der VCSELs ein, wie erzielbare Modulationsbandbreite, emittierte Leistung, Anwendungen und so weiter.

Aus der US-PS 5,426,657 (erteilt an D. Vakshoori) ist bereits ein Laser bekannt, der auf seiner Oberseite mit einer Fresnel-Zonen-Struktur versehen ist. Bei dem Laser kann es sich um insbesondere einen VCSE-Laser handeln. Beschrieben wird, dass bei einem GaAsAl-Laser durch herkömmliche Photolithographie und reaktives Ionenätzen die Ringstrukturen der Fresnel-zonen gebildet werden sollen. In einem Aufsatz von D. Vakshoori et al., Appl.Phys. Lett 65 (2) 11 Juli. 1994, S. 144 ff., wird zum einen vorgeschlagen, über einer Fresnelzonenstruktur einen durchsichtigen Kontakt aufzubringen, indem eine Goldschicht aufgedampft wird, gefolgt von Ionenimplantation zur Strombegrenzung und Sauerstoffimplantierung zur Isolation. Zum anderen wird vorgeschlagen, eine Goldschicht über einer Fresnelzonenstruktur vorzusehen und dann eine Trockenätzung zur Strombegrenzung und Isolation vorzunehmen. Dass ein Multimodeverhalten die Fokussierbarkeit beeinträchtigt und dass Asymmetrien die konvergierende Natur des Laserausgangs beeinflussen, wird erwähnt.

Ein Halbleiterlaser mit einer Fresnelzonenstruktur ist auch aus JP 64001290 A bekannt.

Aus der DE 696 01 948 T2 ist eine optische Resonanzstruktur bekannt, die eine erste und eine zweite Reflexionseinrichtung enthält, die räumlich voneinander getrennt sind, um einen optischen Resonator bereitzustellen, der eine relativ kleine Dickenausdehnung zwischen den Reflexionseinrichtungen aufweist und sich in einer Ebene quer zur Dickenausdehnung über einen Bereich mit relativ großer Querausdehnung erstreckt, wobei Reflexionseinrichtungen zum Reflektieren einer parallel zur Ebene verlaufenden optischen Strahlungskomponente aus dem Resonator mit einer Phasencharakteristik zur Unterstützung eines vorausgewählten senkrechten Resonanzmodus im Resonator vorgesehen sind.

Aus T. Erdogan et al., Appl. Phys. Lett. 60(16) 20. April 1992, S. 1921 ff ist ein angeblich niederdivergenter oberflächenemittierender Laser mit einem Gitter aus konzentrischen Kreisen bekannt. Die Gitterherstellung soll mit Molekularstrahlepitaxie erfolgen.

Es ist wünschenswert, VCSEL-Laser, das heißt Vertikal-Resonator-Laser, in hoher Qualität preisgünstig bereitstellen zu können.

Die Aufgabe der vorliegenden Erfindung besteht darin, Neues für die gewerbliche Anwendung bereitzustellen.

Die Lösung dieser Aufgabe wird in unabhängiger Form beansprucht.

Die vorliegende Erfindung geht also aus von einem Vertikal-Resonator-Laser mit einer Oberfläche zur Strahlemission und einer Beugestruktur zur Bestimmung von Strahleigenschaften, wobei die Beugestruktur eine Fresnel-Zonen-Platte an der strahlemittierenden Oberfläche umfasst. Dabei wird die Zonen-Platte nach einem wesentlichen Aspekt eines Teils der Erfindung gitterangepasst zu einem darunterliegenden Material gebildet sein.

Die vorliegende Erfindung hat erkannt, dass so der bislang erforderliche große Aufwand für die Herstellung eines Vertikal-Resonator-Lasers mit strahlformenden optischen Elementen entbehrlich ist, weil die Fresnel-Zonen-Platte auf einfache Weise an der strahlemittierenden Oberfläche vorgesehen werden kann und sich Bauteile hoher Qualität besonders einfach herstellen lassen.

Es wird dabei ein Bauelement bereitgestellt, das bereits eine klar definierte Strahlform besitzt, was für eine Vielzahl von Anwendungen beispielsweise in der Sensorik, der Datenübertragung sowie im Bereich des Druckes und der Medientechnik neue Möglichkeiten eröffnet. Durch die Verwendung der Fresnel-Zonen-Struktur an der strahlemittierenden Oberfläche ist die Erfindung insbesondere auch mit Laserstrahlung einsetzbar, wenn diese innerhalb des gewählten Substrates per se absorbiert wird; weil damit die Materialwahl erleichtert wird, bietet die emissionsoberflächenseitige Fresnel-Zonen-Struktur schon daher wesentlich bessere Möglichkeiten als eine rückseitige beziehungsweise unterseitige Fresnel-Zonen-Platte. Es entfällt überdies das Erfordernis, den lithographischen Maskenprozess bei der Herstellung hochpräzise für Vorder- und Rückseitenstrukturierung abzustimmen.

Typisch ist für die Erfindung, dass der Laser mit einer Beugestruktur versehen ist, die zumindest einen, bevorzugt zwei Bragg-Reflektoren benachbart einer aktiven Schicht umfasst. Dabei kann der obere Bragg-Reflektor der aktiven Schicht benachbart und p-leitend gebildet sein, was den Erhalt einer Kontaktierung durch die Zonenstruktur hindurch erleichtert.

Bevorzugt wird der unterseitige Kontakt als n-Kontakt gebildet.

Besonders gut lässt sich die Erfindung realisieren, wenn sie bei einem Gallium-Arsenid-Laser verwendet wird, insbesondere einem aluminiumdotierten Gallium-Arsenid-Laser. Auf die Möglichkeit, dass er zur Emission variierender Wellenlängen gebildet ist, sei explizit hingewiesen.

Die Fresnel-Zonenplatte kann besonders einfach als Fresnel-Amplituden-Zonenplatte gebildet sein; durch Ausbildung als Fresnel-Phasen-Zonenplatte kann zwar eine höhere Lichtausbeute erreicht werden; bei Ausbildung als Fresnel-Amplituden-Zonenplatte ist es jedoch ohne weiteres möglich, die lichtabsorbierenden/-blockierenden Ringstrukturen mit dem oberseitigen Kontakt zu realisieren. Die Fresnel-Zonenringe, können, ohne dass dies jedoch zwingend wäre, durch mindestens einen Steg leitend verbunden werden und sind dann einfach zur Kontaktierung zu verwenden. Dass anstelle von Stegen auch andere Kontaktierungsmöglichkeiten gegeben sind, sei erwähnt.

Es sei auch erwähnt, dass eine Kontaktierung über die Fresnel-Zonenringe die Stromdichteverteilung durch das Bauelement beeinflussen kann und damit zugleich eine weitere Möglichkeit bietet, auf das Modenverhalten des Lasers Einfluss zu nehmen.

Es sei zugleich erwähnt, dass anstelle einer Kontaktierung über die erhaben stehenden Zonenringe auch eine Kontaktierung über die Zonenlücken erfolgen kann, wozu gegebenenfalls die erhaben stehenden Zonenringe mit einer Isolatorschicht versehen werden können. Erwähnt sei auch, dass eine Kontaktierung über nur einige der erhaben stehenden Zonenringe und/oder Zonenlücken erfolgen kann, während gleichzeitig andere erhaben stehenden Zonenringe und/oder Zonenlücken nicht der Kontaktierung dienen. Dies erlaubt eine weitgehende Beeinflussung der räumlichen Stromdichteverteilung und damit des räumlichen Modenverhaltens des Lasers. Es sei erwähnt, dass über unterschiedliche Zonenstrukturelemente bewusst unterschiedliche Stromdichten in bestimmten Bereichen vorgesehen werden können, etwa durch integrierte oder separate Vorwiderstände, und es sei erwähnt, dass die Kontaktierung über den oberseitigen Kontakt unter Beeinflussung der Stromdichteverteilung durch Verwendung der Zonenstrukturen in der beschriebenen Art und Weise nicht zwingend an die Verwendung mit einem VCSEL-Laser gebunden ist, der eine Zonenstruktur aus gitterangepasstem Material besitzt. Obwohl es besonders bevorzugt und ohne weiteres möglich ist, eine Zonenstruktur aus gitterangepasstem Material zur nicht vollflächigen, sondern nur partiell die Zonenstrukturfläche nutzenden Kontaktierung zu verwenden, wird daher eine separate Erfindung in der Erkenntnis gesehen, dass eine Stromdichteverteilung bei einer Kontaktierung durch die für die Stromdurchleitung nur partiell genutzte Zonenstruktur besonders einfach so beeinflusst werden kann, dass sich ein vorteilhaftes Modenverhalten ergibt. Teilanmeldungen usw. hierauf bleiben vorbehalten. Es sei auch erwähnt, dass sich bei Kreisringanordnungen für die Zonenstruktur die Stromdichteverteilung besonders vorteilhaft beeinflussen lässt, wenn die Kontaktierung durch die Zonenstruktur hindurch erfolgt.

Das diffraktive optische Element der vorliegenden Erfindung wird bevorzugt zusätzlich zu Bragg-Beugereflektionsstrukturen vorgesehen. Besonders bevorzugt ist es dabei, wenn die Fresnel-Zonen-Platte integral mit dem oberen (emissionsflächenseitigen) Bragg-Reflektor gebildet wird, das heißt monolithisch in dessen Oberfläche integriert wird, was bei Wahl gitterangepassten Materials problemfrei möglich ist.

Die integrale Ausbildung ist nicht nur wegen der vereinfachten Herstellung bevorzugt, sondern auch, weil sie überdies besonders temperaturstabil ist, weshalb sich der oberflächenemittierende Vertikal-Resonator-Laser der vorliegenden Erfindung auch für kritische Anwendungen wie den Automobilbereich besonders eignet und damit ein nicht nur kostengünstiges und effizientes, sondern auch universell einsetzbares optoelektronisches Bauelement darstellt.

Die Anordnung einer Zonen-Platte an der strahlemittierenden Oberfläche führt nicht zu erhöhten, jedenfalls nicht zu signifikant erhöhten Fertigungskosten für den Vertikal-Resonator-Laser, da die Zonen-Platte fotolithographisch strukturiert werden kann, und bei der Vertikalresonanzherstellung ohnehin in der Regel ein Prozessschritt zur Strukturierung eines Austrittsfensters erforderlich ist. Damit werden weder zusätzliche Schritte noch die damit verbundene Verlängerung der Fertigungsdauer bei Verwendung der Erfindung auftreten. Dies ist ein deutlicher Vorteil gegenüber Zonenstruktur-Herstellungstechniken aus dem Stand der Technik.

Erwähnt sei, dass bevorzugt die Fresnel-Zonenstruktur den strahlemittierenden Bereich der Oberfläche zumindest partiell, bevorzugt vollständig überdeckt.

Die Erfindung erlaubt bei Verwendung geeigneter Materialsysteme die Verwendung selektiver Ätzlösungen, das heißt einen Angriff auf nur eines der beiden Materialsysteme. Es lassen sich damit hochgenaue Tiefenstrukturierungen erreichen.

Bei gitterangepassten Strukturen ist einsichtig, dass diese die Reflektionseigenschaften des oberen Reflektors oftmals wenig bis gar nicht stören sollen (dass eine geringe Störung allerdings ohnehin unkritisch ist, da zur Strahl-Auskopplung eine von 100 % verschiedene Reflektion benötigt wird, sei erwähnt). Besonders geeignet ist dazu beispielsweise für einen im Roten emittierenden Laser eine AlGaInP-Schicht, die für rotes Licht transparent ist, gitterangepasst auf AlGaAs abgeschieden werden kann. Bei geeigneter Dicke der AlGaAs-Schicht ergeben sich praktisch keine Reflektivitätsveränderungen für die darunter liegenden Bragg-Reflektoren.

Wenn ein Feld von VCSELs verwendet wird, ist es möglich und bevorzugt, Zonen-Platten so herzustellen, dass das Licht aus den einzelnen Elementen eines Arrays auf denselben Fokuspunkt gerichtet wird. Dies erleichtert die Einkopplung von Licht aus einem Array in eine einzelne Faser in ganz erheblichem Maß und erlaubt somit auf besonders einfache Weise einen Pseudo-Dauerstrich-Betrieb, bei welchem einzelne VCSEL-Elemente eines Arrays alternierend Licht emittieren. Die Möglichkeit eines Multiplexbetriebs sei gleichfalls erwähnt. So können zum Beispiel unterschiedliche Laser in Lichtleiterfasern zeitlich kurz nacheinander ohne weiteres einstrahlen.

Die Erfindung wird im Folgenden nur beispielsweise anhand der Zeichnung beschrieben. In dieser ist dargestellt durch

Fig. 1     ein Vertikal-Resonator-Laser nach der vorliegenden Erfindung;
Fig. 2     eine Fresnel-Zonenplatte-Kreisringstruktur;
Fig. 3     das Reflektivitätsverhalten für in der Erfindung anwendbare Schichten.

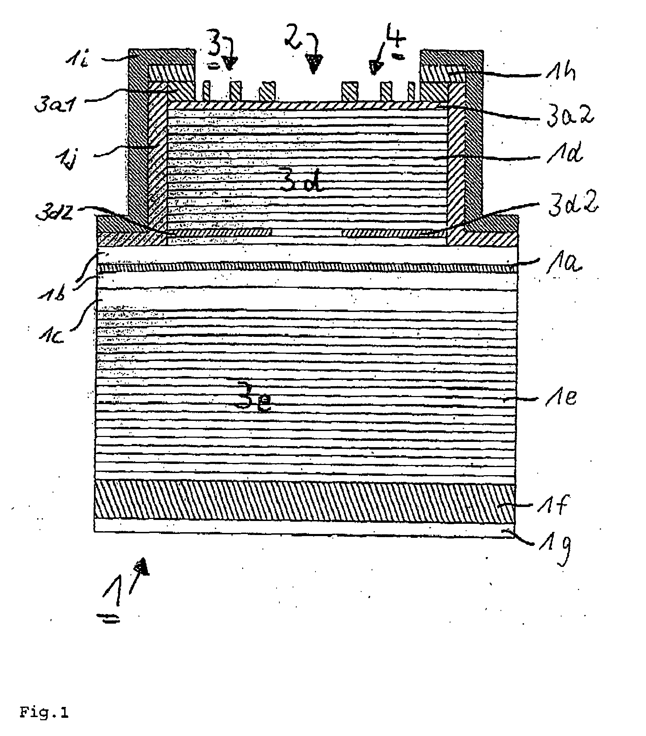

Nach Figur 1 umfasst ein allgemein mit 1 bezeichneter Vertikal-Resonator-Laser eine Oberfläche 2 zur Strahlemission und eine Beugestruktur 3 zur Bestimmung von Strahleigenschaften, wobei die Beugestruktur 3 zur Bestimmung von Strahleigenschaften eine Fresnel-Zonen-Platte 4 an der strahlemittierenden Oberfläche 2 umfasst.

Im dargestellten Ausführungsbeispiel ist der Vertikal-Resonator-Laser 1 mit einer aktiven Zone 1a gebildet, die vorliegend einen Quantentrog in Form von hier Quantenfilmen aus Gallium-Indium-Phosphid (GaInP) umfasst. Dass statt eines einzelnen Quantentrogs mehrere Quantentröge vorgesehen sein können, sei erwähnt. Auch sind anstelle von und/oder zusätzlich zu einem oder mehreren Quantenfilmen auch Quantenpunkte, Quantendrähte und so weiter einsetzbar. Benachbart der aktiven Zone 1a sind Mantelbereiche 1b vorgesehen, wie per se bekannt. An den Mantelbereich 1b schließt sich wiederum eine Halbleiterschicht mit hoher Wärmeleitung 1c an, die dazu ausgebildet ist, die im Vertikal-Emissions-Laser und insbesondere der aktiven Zone 1a entstehende Wärme nach außen abzuleiten, wie dies beispielsweise beschrieben ist in der DE 10 2005 010 933 A1 oder der US 6,714,573 B2.

Der einzelne Mantelbereich kann eine Dicke entsprechend dem (2k+1)/4-fachen der Emissionswellenlänge des VCSEL aufweisen. Beidseits der Mantel- beziehungsweise Wärmeleitschichten 1b beziehungsweise 1c sind Bragg-Reflektorschichten vorgesehen, und zwar eine obere Bragg-Reflektorschicht 3d und eine untere Bragg-Reflektorschicht 3e. Wie erkennbar, besitzt die untere Bragg-Reflektorschicht 3e mehr Schichten als die obere Bragg-Reflektorschicht 3d. Sie ist damit höher reflektierend. Aus der oberen Bragg-Reflektorschicht, die weniger Schichten und damit eine geringere Reflektivität aufweist, kann das Licht wie noch beschrieben wird, zur Oberfläche 2 hin austreten.

Ein Beispiel für einen Vertikal-Resonator-Laser ist in der US 5,764,671 gezeigt. Die Bragg-Reflektoren 3d und 3e sind aus Paaren alternierend hoch und nieder brechender Schichten gebildet. Bei dem hier beschriebenen Vertikal-Resonator-Laser mit einer aktiven GaInP-Zone können die Bragg-Reflektoren beispielsweise aus Aluminium-Gallium-Arsenid, Aluminium-Gallium-Indium-Phosphid (AlGaInP) oder anderen Materialien hergestellt werden. Falls erwünscht, kann in vorteilhafter Weise ein Teil der Bragg-Reflektorschichten, insbesondere der hochaluminiumhaltigen Schichten der Bragg-Reflektoren, selektiv oxidiert werden, wie dies bei 3d2 angedeutet ist. Dies verringert, wie in der US 5,359,618 beschrieben, die Schwellstromdichte und die durch den Strom erzeugte Wärme.

Der untere Bragg-Reflektor 3e ist im dargestellten Ausführungsbeispiel als hier n-leitender Bragg-Reflektor gebildet und auf einem Substrat 1f mit unterseitigem n-Kontakt 1g gebildet.

Der obere Bragg-Reflektor 3d ist mit einer elektrischen Kontaktschicht 1h versehen, auf welcher ein elektrischer Kontakt 1i angeordnet ist. Um den elektrischen Kontakt 1i von der verbleibenden Struktur zu trennen, ist eine Isolatorschicht 1j vorgesehen.

Die Strahlemission durch die Oberfläche findet im vorliegenden Beispiel in Luft hinein statt, was aber nicht zwingend ist. Wie nachfolgend deutlicher wird, ist dies lediglich im Hinblick auf den Unterschied der Brechungsindizes zwischen dem umgebenden Material und der obersten Schichten des Vertikal-Resonator-Lasers von Bedeutung.

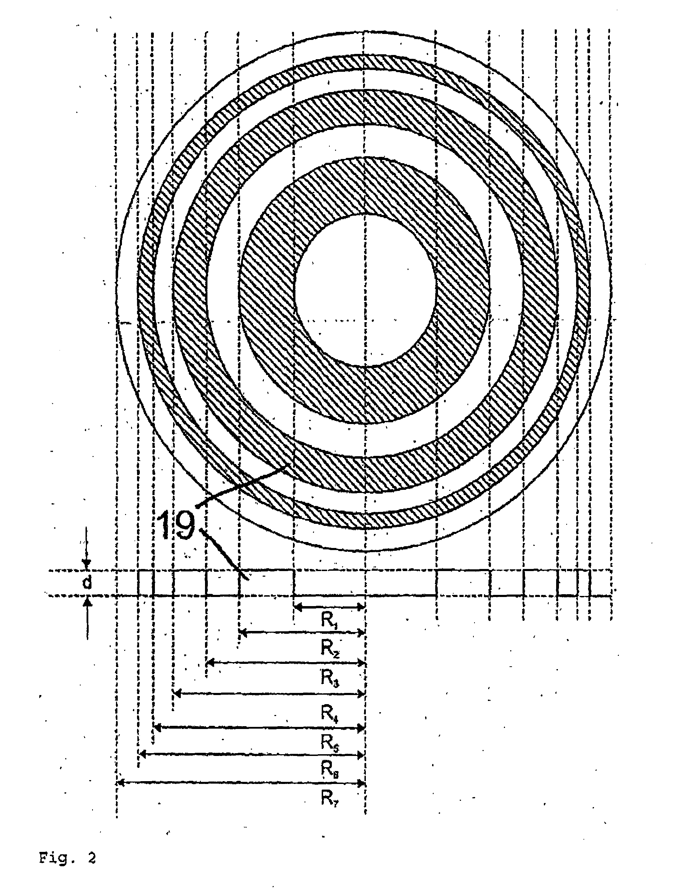

Die Beugestruktur zur Bestimmung der Strahleigenschaften 3 ist nun erfindungsgemäß mit einer Fresnel-Zonen-Platte gebildet, die in Fig. 2 in Draufsicht gezeigt ist. Im dargestellten Ausführungsbeispiel handelt es sich um eine Phasen-Fresnel-Zonen-Platte, die aus einem Material, hier AlGaInP gebildet ist, welches bei der Laserwellenlänge einen von jenem des Umgebungsmediums oberhalb der Grenzfläche verschiedenen Brechungsindex aufweist; dass alternativ eine Fresnel-Amplituden-Zonen-Platte verwendet werden kann, sei erwähnt. In einem solchen Fall kann eine Kombination aus einer Kontaktschicht, wie bei 1h, auf welcher der elektrische Kontakt 1i aufgebracht ist, und einer Schicht aus transparentem Material wie AlGaInP verwendet werden. Bei Verwendung einer Fresnel-Phasen-Zonen-Platte ist die Schichtdicke von Bedeutung. Sie sollte bestimmt sein nach

$$\text{Dicke} = \lambda \ / \ (2 \ \Delta_n \ (2j + 1)),$$

wobei

j = 0,1,2,
$\lambda$ = Emissionslaserwellenlänge und

$\Delta_n$ = Brechungsindexunterschied

zwischen Umgebungsmaterial und Material der Fresnel-Phasen-Zonen-Platte. Bei der dargestellten Amplituden-Fresnel-Zonen-Platte ist die Dicke der Schicht hingegen vergleichsweise unbedeutend. Sie ist als Kontaktschicht für die Stromzuführung zum p-leitenden oberen Bragg-Reflektor 1d gebildet und im übrigen so strukturiert, dass kreisringweise Material entfernt ist, wobei die Kreisringe unterschiedliche Breite besitzen, wie in Fig. 2 in der Draufsicht angedeutet. Die Radien der einzelne Kreise bestimmen sich dabei wie folgt:

$$R_1 = \sqrt{\left(f + \frac{\lambda}{2}\right)^2 - f^2} \cdot \sqrt{m}$$

wobei

m = 1, 2, 3, 4
f = gewünschte Brennweite

die sich mit den Größen

$W_0$ = Strahltaille des Laserstrahls in der Struktur
n = Brechungsindex der zu strukturierenden Schicht 3
$\lambda$ = Laseremissionswellenlänge,
S = Abstand der lichterzeugenden aktiven Zone 1a zur Zonenplatte 3

und

S1 = gewünschter Fokusabstand zur Oberfläche bestimmt nach

$$\frac{S_1}{f} = \frac{S(S - nf) + \frac{\pi^2 n^2 W_0^4}{\lambda^2}}{(S - nf)^2 + \frac{\pi^2 n^2 W_0^4}{\lambda^2}}$$

Es sei erwähnt, dass die Kreisringstruktur für Phasen- und Amplituden-Zonen-Platten per se gleich ist. Weiter sei darauf hingewiesen, dass die Kanten der Ringe und der Ringoberflächen senkrecht verlaufen, also nicht abgeschrägt sind wie bei einer Fresnel-Linse. Dass für sehr ausgefallene Strahlformungen gegebenenfalls auch nichtorthogonale Blöcke bei einer phasen- und/oder amplitudenmodulierenden Fresnel-Zonen-Platte realisierbar sein könnten, sei der Vollständigkeit halber erwähnt.

Die Fresnel-Zonen-Platte kann insbesondere, wie auch im dargestellten Ausführungsbeispiel, hergestellt sein durch einen photolithographischen Maskenprozess mit einem nachfolgenden, hier nasschemisch erfolgenden Ätzschritt; dass anstelle eines nasschemischen Ätzschrittes auch eine Ionenätzung erfolgen kann, sei erwähnt. Die nasschemische Ätzung ist jedoch deshalb bevorzugt, weil es mit ihr möglich ist, eine selektive Ätzung vorzunehmen. Dazu werden die obersten Sichten 3a1 und 3a2 des Bragg-Reflektors strukturiert, die zugleich die Fresnel-Zonen-Platte bilden und somit integral mit dem oberen Bragg-Reflektor aus einer geeigneten Schichtpaarkombination gebildet sind, nämlich hier durch eine oberste Schicht 3a1, die phosphorbasiert ist und aus AlGaInP besteht, so wie einer darauf folgenden AlGaAs-Schicht. Diese Schichtkombination erlaubt es, eine selektiv auf phosphorbasierte Materialen einwirkende Ätzlösung zu verwenden. Der Ätzprozess endet bei diesen selbständig und damit ohne Eingriff von außen auf der darunter liegenden As-basierenden Schicht, so dass durch das Ätzen die gewünschte Dicke d der Schicht mit jener Präzision bestimmt werden kann, die auch beim Wachstum erreicht wird. Die Schichtdicke ist somit hochpräzise bestimmbar.

Es sei erwähnt, dass es auch bei selektiv ätzbaren Schichten möglich ist, zwei im Ätzverhalten unterschiedliche, gitterangepasste Schichten mit dennoch gleichem Brechungsindex zumindest im Laserwellenlängenbereich zu verwenden; dies ist offensichtlich bevorzugt. Eine besonders bevorzugte Kombination, mit der dies möglich ist, wird zum Beispiel erhalten, wenn

für die Schicht 3a2 ein AlGaAs mit 50 % Al

und

für die Schicht 3a1 ein AlGaInP mit ca. 15 % Al-Gehalt

verwendet wird (wobei zum Beispiel bei dem "AlGaAs mit 50 % Al" von den Ga-Atomen im GaAs-Gitter die Hälfte, also 50 % ersetzt sind durch Al-Atome).

Dass Variationen dieser Prozentangaben möglich sind, ohne die wesentlichen Vorteile der Gitterangepasstheit, der angepassten Brechungsindizes und der selektiven Ätzbarkeit zu verlieren, sei erwähnt. So ist abzusehen, dass Abweichungen von etwa $\pm$ 5 % zumindest weitgehend unkritisch sein können. Für andere Emissionswellenlängen als im sichtbar Roten emittierende Laser lassen sich einleuchtenderweise gleichfalls geeignete Materialpaarungen finden.

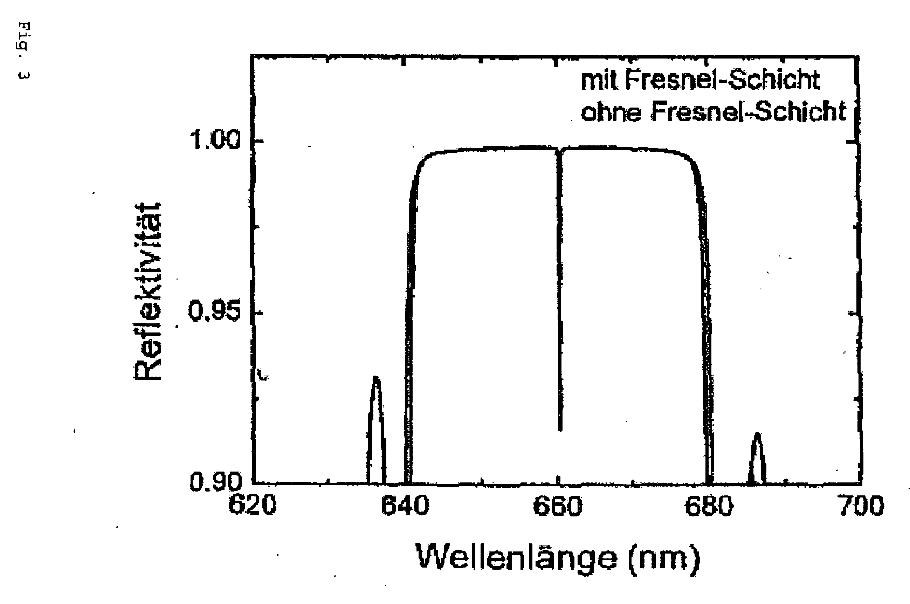

Die Anordnung der vorliegenden Erfindung wurde beispielhaft realisiert mit einer Phasen-Fresnel-Zonen-Platte auf der Oberfläche eines bei 660 nm eine $TEM_{00}$-Mode emittierenden VCSELs. Die zu strukturierende Oberfläche wurde aus AlGaInP mit einem Aluminiumgehalt von 33 % gebildet, das auf einer darunter liegenden AlGaAs-Schicht liegt. Die Reflektorschicht und/oder Fresnel-Zonen-Platte ist in Fig. 3 gezeigt. Diese Materialkombination erlaubt den Einsatz selektiver Ätzlösungen. Der Brechnungsindex der AlGaInP-Schicht beträgt n = 3,38. Die Schichtdicke beträgt damit 138 nm. Der Abstand der Strahltaille zur Zonenplatte entspricht etwa der Summe der Schichtdicken zwischen aktiver Zone und Zonenplatte und damit für typische Vertikal-Resonator-Laser etwa 3,8 $\mu$m. Die Strahltaille selbst hat einen ungefähren Durchmesser von 15 $\mu$m. Da eine Fasereinkopplung einen Abstand zwischen Faser und Zonenplatte von um 0,5 mm erfordert, ergeben sich die folgenden ersten sieben Radien

$R_1$ = 32 $\mu$m
$R_2$ = 45 $\mu$m
$R_3$ = 55,5 $\mu$m
$R_4$ = 64 $\mu$m
$R_5$ = 71, 5$\mu$m
$R_6$ = 75,5 $\mu$m und
$R_7$ = 85$\mu$m.

Die Differenzen der aufeinander folgenden Radien und damit die zu strukturierende Kreisringbreite liegen somit im $\mu$-Bereich. Dies konnte mit herkömmlicher optischer Photolithographie leicht hergestellt werden.

Dass anstelle von Fresnel-Zonen-Platten für $TEM_{00}$-Moden auch solche für andere Strahlemissionsmoden entwerfbar sind, sei erwähnt. Dies ist vorteilhaft für höhere Strahlenergien usw. Die Zonenstruktur ist somit in der Regel emissionsmodenangepasst.

**Patentansprüche**

1. Vertikal-Resonator-Laser mit einer Oberfläche zur Strahlemission und einer Beugestruktur zur Bestimmung von Strahleigenschaften, die eine Fresnel-Zonen-Flatte an der strahlemittierenden Oberfläche umfasst, **dadurch gekennzeichnet, dass** die Fresnel-Zonen-Platte mit Material gebildet ist, das zu einem darunter liegenden Material gitterangepasst ist.

2. Vertikal-Resonator-Laser nach einem der vorhergehenden Ansprüche, **dadurch gekennzeichnet, dass** die Fresnel-Zonen-Platte durch selektives Ätzen hergestellt ist.

3. Vertikal-Resonator-Laser nach einem der vorhergehenden Ansprüche, **dadurch gekennzeichnet, dass** er als Gallium-Arsenid-Laser gebildet ist, insbesondere als aluminiumdotierter Gallium-Arsenid-Laser.

4. Vertikal-Resonator-Laser nach einem der vorhergehenden Ansprüche, **dadurch gekennzeichnet, dass** die Fresnel-Zonen-Platte als amplitudenmodulierende Fresnel-Zonen-Platte gebildet ist.

5. Vertikal-Resonator-Laser nach einem der vorhergehenden Ansprüche, **dadurch gekennzeichnet, dass** die Fresnel-Zonenplatte als Kontaktschicht für die Stromzuführung gebildet ist.

6. Vertikal-Resonator-Laser nach einem der vorhergehenden Ansprüche, **dadurch gekennzeichnet, dass** die Beugestruktur weiter zumindest einen, bevorzugt zwei Bragg-Reflektoren benachbart einer aktiven Schicht umfasst.

7. Vertikal-Resonator-Laser nach einem der vorhergehenden Ansprüche, **dadurch gekennzeichnet, dass** zumindest der obere Bragg-Reflektor der aktiven Schicht benachbart und p-leitend gebildet ist.

8. Vertikal-Resonator-Laser nach einem der vorhergehenden Ansprüche, **dadurch gekennzeichnet, dass** die Fresnel-Zonen-Platte integral mit dem emissionsflächenseitigen Bragg-Reflektor gebildet ist.

9. Vertikal-Resonator-Laser nach einem der vorhergehenden Ansprüche, **dadurch gekennzeichnet, dass** die Fresnel-Zone den strahlemittierenden Bereich der Oberfläche zumindest partiell, bevorzugt vollständig überdeckt.

10. Vertikal-Resonator-Laser nach einem der vorhergehenden Ansprüche, **dadurch gekennzeichnet, dass** die Fresnel-Zonen-Platten mit Kreisring-Strukturen gebildet ist.

11. Vertikal-Resonator-Laser nach einem der vorhergehenden Ansprüche, **dadurch gekennzeichnet, dass** er zur Emission variierender Wellenlängen gebildet ist.

12. Vertikal-Resonator-Laser nach einem der vorhergehenden Ansprüche, **dadurch gekennzeichnet, dass** er zur Emission einer oder mehrerer von im Roten liegenden Wellenlängen gebildet ist.

13. Vertikal-Resonator-Laser nach einem der vorhergehenden Ansprüche, **dadurch gekennzeichnet, dass** er einen unterseitigen n-Kontakt aufweist.

14. Verfahren zur Herstellung eines Vertikal-Resonator-Lasers mit Fresnel-Zonen-Platte an der strahlemittierenden Oberfläche insbesondere nach einem der vorhergehenden Ansprüche, **dadurch gekennzeichnet dass** die Fresnel-Zonen-Platte mit Material gebildet wird, das zu einem darunter liegenden Material gitterangepasst ist.

Fig.1

Fig. 2

Fig. 3

Europäisches
Patentamt

European
Patent Office

Office européen
des brevets

## EUROPÄISCHER RECHERCHENBERICHT

Nummer der Anmeldung

EP 09 00 3664

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 614 255 A (AT & T CORP [US]) 7. September 1994 (1994-09-07) * Spalte 2, Zeile 7 - Spalte 4, Zeile 19; Abbildungen 1-3,5 * ----- | 1-14 | INV. H01S5/026 H01S5/183 ADD. H01S5/20 |
| X | WO 2005/071808 A (NIPPON ELECTRIC CO [JP]; ANAN TAKAYOSHI [JP]) 4. August 2005 (2005-08-04) * die Referenzen beziehen sich auf das Familienmitglied US-A-2008/232 418 * -& US 2008/232418 A1 (ANAN TAKAYOSHI [JP]) 25. September 2008 (2008-09-25) * Absätze [0023] - [0036], [0049] - [0058]; Abbildungen 1-3 * ----- | 1,3,4, 6-14 | |
| X | RASTANI K: "INTEGRATION OF PLANAR FRESNEL MICROLENSES WITH VERTICAL-CAVITY SURFACE-EMITTING LASER ARRAYS" OPTICS LETTERS, OSA, OPTICAL SOCIETY OF AMERICA, WASHINGTON, DC, US, Bd. 16, Nr. 12, 15. Juni 1991 (1991-06-15), Seiten 919-921, XP000216268 ISSN: 0146-9592 * Seite 919, linke Spalte - Seite 921, linke Spalte; Abbildungen 1,2 * ----- | 1,3,5-7, 9-14 | |
| A | US 2004/108508 A1 (NISHIGUCHI HARUMI [JP] ET AL) 10. Juni 2004 (2004-06-10) * Absätze [0025] - [0029], [0041] - [0043]; Abbildung 2 * ----- | 2 | |

RECHERCHIERTE SACHGEBIETE (IPC)

H01S

Der vorliegende Recherchenbericht wurde für alle Patentansprüche erstellt

| Recherchenort | Abschlußdatum der Recherche | Prüfer |
|---|---|---|
| München | 26. Juni 2009 | Laenen, Robert |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 09 00 3664

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-06-2009

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 0614255 | A | 07-09-1994 | DE | 69405427 | D1 | 16-10-1997 |
| | | | DE | 69405427 | T2 | 02-04-1998 |
| | | | JP | 3102742 | B2 | 23-10-2000 |
| | | | JP | 6326417 | A | 25-11-1994 |
| | | | US | 5426657 | A | 20-06-1995 |
| WO 2005071808 | A | 04-08-2005 | US | 2008232418 | A1 | 25-09-2008 |
| US 2008232418 | A1 | 25-09-2008 | WO | 2005071808 | A1 | 04-08-2005 |
| US 2004108508 | A1 | 10-06-2004 | CN | 1499684 | A | 26-05-2004 |
| | | | CN | 1848567 | A | 18-10-2006 |
| | | | DE | 10351394 | A1 | 09-06-2004 |
| | | | JP | 2004158615 | A | 03-06-2004 |
| | | | KR | 20040040377 | A | 12-05-2004 |
| | | | KR | 20060112257 | A | 31-10-2006 |
| | | | TW | 246812 | B | 01-01-2006 |

EPO FORM P0461

Für nähere Einzelheiten zu diesem Anhang : siehe Amtsblatt des Europäischen Patentamts, Nr.12/82

# EP 2 101 379 A1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1309051 B1
- EP 1309051 A
- US 6597713 B2
- US 6597713 B
- US PS5426657 A
- JP 64001290 A
- DE 69601948 T2
- DE 102005010933 A1
- US 6714573 B2
- US 5764671 A
- US 5359618 A

**In der Beschreibung aufgeführte Nicht-Patentliteratur**

- **von R. Roßbach et al.** Red VCSEL for High-Temperature Applications. *J. Crystal Growth,* 2004, vol. 272, 549
- **von R. Roßbach et al.** AlGaInP-based-VCSEL2005. *IEEE Catalog Number 05CH37633C,* 2005, 161
- Red VCSEL for Last Mile Networks. **von M. Eichfelder et al.** ITG-Fachbericht 197, Kommunikationskabelnetze. VDE-Verlag, vol. 256, 151
- **von M. Jetter et al.** Red light VCSEL for high temperature application. *SPIE 5594,* 2004, 141
- **von T. Ballmann et al.** Analog Modulation of 650 nm VCSEL. *IEEE Phot. Tech. Lett.,* 2006, vol. 18 (4), 583 ff
- **von H. Schweizer et al.** Red surface emitters: powerful and fast. *SPIE 5248,* 2003, 103
- **von R. Roßbach et al.** Red VCSEL for automotive applications. *SPIE 5663,* 2004, 135
- **von R. Roßbach et al.** 160°C pulsed laser operation of AlGaInP-based vertical-cavity surface-emitting lasers. *Electron. Lett.,* 13. November 2003, vol. 39 (23
- **D. Vakshoori et al.** *Appl.Phys. Lett,* 11. Juli 1994, vol. 65 (2), 144 ff
- **T. Erdogan et al.** *Appl. Phys. Lett.,* 20. April 1992, vol. 60 (16), 1921 ff